**Europäisches Patentamt**

**European Patent Office**

**Office européen des brevets**

(11) Veröffentlichungsnummer: **0 182 101 B1**

(12) **EUROPÄISCHE PATENTSCHRIFT**

(45) Veröffentlichungstag der Patentschrift: **13.03.91**

(51) Int. Cl.5: **H03K 17/04,** H03K 17/64, F02D 41/20

(21) Anmeldenummer: **85113155.7**

(22) Anmeldetag: **17.10.85**

(54) Schalteinrichtung zum schnellen Schalten eletromagnetischer Verbraucher.

(30) Priorität: **23.11.84 DE 3442764**

(43) Veröffentlichungstag der Anmeldung:
**28.05.86 Patentblatt 86/22**

(45) Bekanntmachung des Hinweises auf die
Patenterteilung:
**13.03.91 Patentblatt 91/11**

(84) Benannte Vertragsstaaten:
**DE FR GB**

(56) Entgegenhaltungen:
EP-A- 0 047 614
EP-A- 0 074 536
FR-A- 2 538 942
US-A- 4 377 144
US-A- 4 452 210

(73) Patentinhaber: **ROBERT BOSCH GMBH
Postfach 50
W-7000 Stuttgart 1(DE)**

(72) Erfinder: **Kubach, Hans, Dipl.-Ing.
Danziger Strasse 9
W-7015 Korntal-Münchingen 2(DE)**
Erfinder: **Rupp, Hartmann, Dipl.-Ing. (FH)
Härtestrasse 6
W-7140 Ludwigsburg(DE)**

## Beschreibung

Bei der Erfindung handelt es sich um eine Schalteinrichtung zum schnellen Schalten elektromagnetischer Verbraucher nach der Gattung des Oberbegriffs des Hauptanspruchs.

Eine Schalteinrichtung mit den Merkmalen des Oberbegriffs des Anspruchs 1 ist aus EP-A-o 074 536 der Anmelderin bekannt. Bei dieser Schalteinrichtung kann ein Kondensator zeitweilig parallel zu einer Schaltvorrichtung geschaltet werden, wenn diese sich in dem leitenden Zustand befindet. Während dieser Phase wird der Kondensator aufgeladen. Im Sperrzustand der Schaltvorrichtung wird der aufgeladene Kondensator mit einem Entladekreis verbunden, der ein RC-Glied umfaßt. Durch den Entladestrom wird der Strom durch einen in Serie zu der Schaltvorrichtung geschalteten elektromagnetischen Verbraucher simuliert, der während der Sperrphase der Schaltvorrichtung nicht erfaßbar ist.

Aus FR-A-2 538 942 ist eine Kapazität bekannt, die parallel zu einer Schaltvorrichtung geschaltet ist und über eine serielle Diode angesteuert wird. Weiter wird diese Kapazität auch über eine Schaltvorrichtung seriell angesteuert.

Aus EP-A-0 047 614 ist ein Freilaufkreis bekannt, bei dem ein Kondensator über die Serienschaltung einer Schaltvorrichtung und einer Diode aufladbar ist.

Schließlich ist aus US-A-4 452 210 ein Schaltkreis zur Ansteuerung eines Einspritzventils bekannt, der zu verschiedenen Zeitpunkten unterschiedliche Spannungspegel zur Ansteuerung des Einspritzventils erzeugt.

Die erfindungsgemäße Schalteinrichtung zum schnellen Schalten elektromagnetischer Verbraucher mit den Merkmalen des Hauptanspruchs hat gegenüber dem beschriebenen Stand der Technik den Vorteil, daß mit ihr kurze Schaltzeiten des elektromagnetischen Verbrauchers, niedrige Verlustleistungen innerhalb der Schaltung, sowie der Aufbau eines Zeit-Regelkreises realisierbar ist. Dies wird dadurch erreicht, daß parallel zum Schalttransistor eine steuerbare Kapazität angebracht ist.

Besonders vorteilhaft ist es dabei, die Kapazität mit Hilfe der Parallelschaltung einer Diode und eines Transistors zu steuern. Weitere vorteilhafte Weiterbildungen und Verbesserungen der im Hauptanspruch angegebenen Einrichtung sind durch die in den Unteransprüchen auf-geführten Maßnahmen möglich.

Ausführungsbeispiele der Erfindung sind in der Zeichnung dargestellt und in der nachfolgenden Beschreibung näher erläutert. Figur 1 zeigt eine mögliche Realisierung der erfindungsgemäßen Schalteinrichtung, Figur 2 ein Spannungs-Strom-Diagramm mit Strombegrenzung, Figur 3 ein Spannungs-Strom-Diagramm ohne Strombegrenzung, sowie Figur 4a bis d Diagramme der Ansteuersignale bei Strombegrenzung.

Bei den beschriebenen Ausführungsbeispielen handelt es sich um Schalteinrichtungen zum schnellen Schalten elektromagnetischer Verbraucher. Prinzipiell sind die beschriebenen Schalteinrichtungen im Zusammenhang mit jeglichen elektromagnetischen Verbrauchern einsetzbar, also nicht auf eine spezielle Anwendung eingeschränkt. Besonders vorteilhaft ist es jedoch, die erfindungsgemäße Schalteinrichtung im Zusammenhang mit Brennkraftmaschinen einzusetzen, insbesondere bei der Zumessung von Kraftstoff in einen Brennraum der Brennkraftmaschine. Zu diesem Zweck kann dann in besonders vorteilhafter Weise ein Magnetventil zur Einspritzung von Kraftstoff in die Brennkraftmaschine verwendet werden.

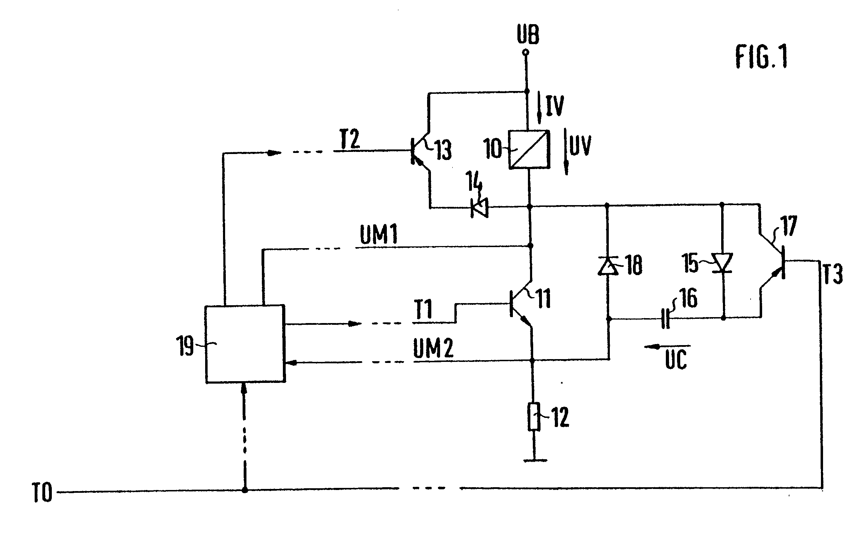

Die Figur 1 zeigt eine mögliche Realisierung der erfindungsgemäßen Schalteinrichtung. In dieser Figur bildet ein Magnetventil 10, ein Schalttransistor 11 und ein Meßwiderstand 12 eine Serienschaltung von der Batteriespannung UB nach Masse. Der Strom, der durch das Magnetventil 10 fließt, ist dabei mit IV bezeichnet, die Spannung am Magnetventil 10 mit UV. Parallel zum Magnetventil 10 führt eine Serienschaltung einer Freilaufdiode 14 und eines Freilauftransistors 13 vom Verbindungspunkt des Magnetventils 10 und des Schalttransistors 11 zur Batteriespannung UB. An der Basis des Freilauftransistors 13 liegt dabei das Ansteuersignal T2. Vom Verbindungspunkt des Magnetventils 10 und des Schalttransistors 11 führt die Parallelschaltung einer Steuerdiode 15 und eines Steuertransistors 17 zu einem Anschlußpunkt einer Steuerkapazität 16. Der zweite Anschlußpunkt dieser Steuerkapazität 16 ist an den Verbindungspunkt des Schalttransistors 11 und des Meßwiderstands 12 angeschlossen. Die Spannung, die an der Steuerkapazität 16 anliegt, ist mit UC gekennzeichnet. Der Steuertransistor 17 wird an seiner Basis mit dem Ansteuersignal T3 beaufschlagt. Parallel zum Schalttransistor 11 liegt des weiteren noch die Diode 18. Der Schalttransistor 11 selbst wird von dem Ansteuersginal T1 angesteuert. Die Spannung, die am Verbindungspunkt von Magnetventil 10 und Schalttransistor 11 liegt, ist mit UM1 bezeichnet, während die Spannung am Verbindungspunkt von Schalttransistor 11 und Meßwiderstand 12 durch UM2 gekennzeichnet ist. Mit der Bezugsziffer 19 ist eine Steuer- und/oder Regeleinrichtung ausgezeichnet. Diese Steuer- und/oder Regeleinrichtung 19 empfängt wenigstens die Signale UM1 , UM2, sowie ein Grund-Ansteuersignal To, und bildet in Abhängigkeit von diesen Eingangssignalen wenigstens ein, oder auch mehrere Ausgangssignale, mit deren Hilfe direkt oder auch indirekt die Transistoren 11 , 13 und 17 angesteuert werden.

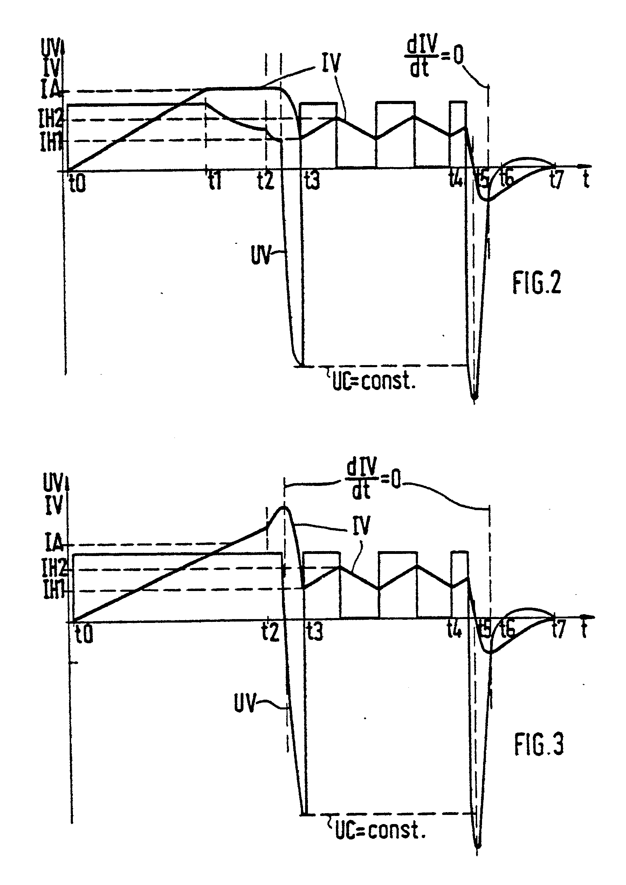

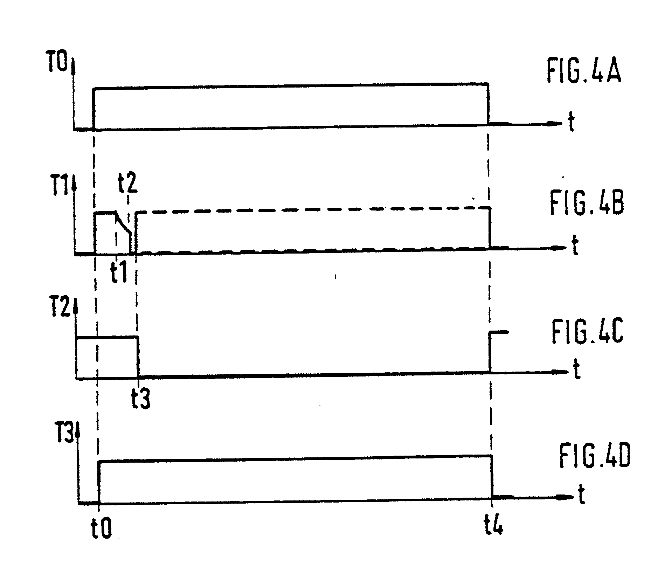

Die Funktionsweise der Realisierung der erfindungsgemäßen Schalteinrichtung gemäß Figur 1 soll mit Hilfe der Figuren 2, 3 sowie 4a bis d im folgenden Text beschrieben werden. Die Figuren 2 bzw. 3 zeigen Spannungs-Strom-Diagramme mit bzw. ohne Strombegrenzung. In diesen beiden Figuren ist die Ventilspannung UV, sowie der Ventilstrom IV über der Zeit aufgetragen. Mit IA ist in den beiden Figuren 2 und 3 der sogenannte Anzugsstrom bezeichnet, also der Strom, der für das Anziehen des Magnetventils, also für den Übergang des Magnetventils von seinem einen in seinen anderen Betriebszustand ausreicht. Mit IH1 und IH2 sind zwei Halteströme gekennzeichnet, die für das Steuern des Stroms durch das Magnetventil den unteren und oberen Stromgrenzwert bilden. Der untere Grenzwert, also der Haltestrom IH1 muß dabei so gewählt werden, daß bei diesem Strom das Magnetventil sicher in seinem bisherigen Betriebszustand verbleibt. Mit den Bezeichnungen t0 bis t7 sind in den Figuren 1 und 2 bestimmte, charakteristische Zeitpunkte gekennzeichnet. Im Zeitpunkt t0 beginnt die Ansteuerung des Magnetventils. Ab dem Zeitpunkt t1 wird der Strom IV durch das Magnetventil begrenzt. Der Zeitpunkt t2 kennzeichnet den sogenannten Ventilanschlag, also den vollständigen Übergang des Magnetventils von seinem einen in seinen anderen Betriebszustand. Ab dem Zeitpunkt t3 wird das Magnetventil taktend angesteuert, der Ventilstrom IV vergrößert und verkleinert sich also regelmäßig. Der Zeitpunkt t4 kennzeichnet das Ende der Ansteuerung des Magnetventils. Im Zeitpunkt t5 weist der Strom IV durch das Magnetventil einen Nulldurchgang auf, während im Zeitpunkt t6 die Spannung UV am Magnetventil einen entsprechenden Nulldurchgang besitzt. Im Zeitpunkt t7 ist der Ventilstrom IV, wie auch die Ventilspannung UV wieder zu Null geworden. Die Figuren 4a bis d zeigen Diagramme der Ansteuersignale bei Strombegrenzung. Dabei ist in Figur 4a das Grund-Ansteuersignal T0 für das Magnetventil dargestellt, in Figur 4b das Ansteuersignal T1 für den Schalttransistor 11 , in Figur 4c das Ansteuersignal T2 für den Freilauftransistor 13 sowie in Figur 4d das Ansteuersignal T3 für den Steuertransistor 17. Die Bezeichnungen für die Zeitpunkte t0 bis t4 entsprechen den Bezeichnungen der Figuren 2 und 3. Insgesamt sind in den Figuren 4a bis d Spannungen über der Zeit aufgetragen. Bei den Spannungen handelt es sich dabei um die Spannungen, die an die Basis der jeweiligen Transistoren angelegt werden. Die Spannungen sind dabei nicht maßstäblich aufgetragen.

Ist vor dem Zeitpunkt t0 das Grund-Ansteuersignal T0 noch auf Masse, so hat dies zur Folge, daß aufgrund der Ansteuersignale T1 , T2, T3 der Figuren 4b bis d der Schalttransistor 11 und der Freilauftransistor 13 gesperrt sind, während der Steuertransistor 17 durchgeschaltet ist. Der Strom IV durch das Magnetventil 10 ist vor dem Zeitpunkt t0 gleich 0. Im Zeitpunkt t0 springt das Grund-Ansteuersignal T0 von Masse auf hohes Potential, das Magnetventil 10 soll jetzt also möglichst schnell in seinen anderen Betriebszustand übergehen. Zu diesem Zweck wird ebenfalls im Zeitpunkt t0 das Ansteuersignal T1 und das Ansteuersignal T3 so verändert, daß der Schalttransistor 11 in seinen leitenden Zustand übergeht, während der Steuertransistor 17 jetzt sperrt. Dadurch springt die Ventilspannung UV auf einen hohen Wert, normalerweise auf den Wert der Batteriespannung UB, und der Ventilstrom IV beginnt langsam größer zu werden. Im Zeitpunkt t1 der Figur 2 überschreitet der Ventilstrom IV mindestens den Wert des Anzugsstroms IA. Jetzt gibt es zwei Alternativen. In der Figur 2 wird ab dem Zeitpunkt t1 der Ventilstrom IV so gesteuert, daß er den Wert des Anzugsstroms IA oder eines noch größeren Stromes beibehält. Dies wird dadurch erreicht, daß aufgrund des Ansteuersignals T1 gemäß der Figur 4b, die Spannung UV am Magnetventil verringert wird. In der Figur 3 hingegen wird keine Strombegrenzung durchgeführt, d.h. , der Strom IV wird nicht auf den Wert des Stroms IA begrenzt. Hier steigt also der Strom IV gleichmäßig an, und die Spannung UV bleibt konstant. Im Zeitpunkt t2 ist das Magnetventil vollständig in seinen anderen Betriebszustand übergegangen. Dies kann in der Figur 2 z.B. dadurch erkannt werden, daß in diesem Ventilanschlagszeitpunkt die Spannung UV am Magnetventil einen Knick aufweist. Durch einen analogen Knick im Strom IV durch das Magnetventil ist in der Figur 3 dieser Ventilanschlag gekennzeichnet. Gemäß der Figur 4b wird in beiden Fällen, also mit und ohne Strombegrenzung, nach dem Erkennen des Zeitpunktes t2 der Schalttransistor 11 abgeschaltet. Es sind jetzt also alle drei Transistoren 11 , 13 und 17 in ihrem nichtleitenden Zustand. Während vor dem Zeitpunkt t2 der Strom IV über das Magnetventil 10, den leitenden Transistor 11 und den Meßwiderstand 12 fließen konnte, so hat jetzt, nach Erkennen des Zeitpunktes t2 und damit bei gesperrtem Transistor 11, der Strom IV nur noch die Möglichkeit über das Magnetventil 10 die Diode 15, die Kapazität 16 und den Meßwiderstand 12 zu fließen, und damit die Steuerkapazität 16 aufzuladen. Wie den Figuren 2 und 3 entnommen werden kann, hat diese Aufladung der Kapazität 16 eine negative Spannung UV am Magnetventil 10 und einen rasch kleiner werdenden Strom IV durch das Magnetventil 10 zur Folge. Wichtig ist, daß der Wert der Spannung UC an der Steuerkapazität 16 wesentlich größer ist als der Wert der Batteriespanung UB, charakteristisch ist hier z.B. ein Faktor 10. Wie eben schon ausgeführt wurde, wird nach der Umschaltung, also nach dem Zeitpunkt t2 der Strom IV durch das Magnetventil 10 kleiner. Im Zeitpunkt t3 erreicht nun der Strom IV den Wert des Haltestroms IH1. Gemäß den beiden Diagrammen der Figur 4b und c werden jetzt der Schalttransistor 11 und der Freilauftransistor 13 in ihre leitenden Betriebszustände übergeführt. Dies hat zur Folge, daß der Strom IV durch das Magnetventil 10 wieder ansteigt. Erreicht der Strom IV dann den Wert des Haltestromes IH2 so wird der Schalttransistor 11 wieder abgeschaltet, wodurch der Strom IV wieder kleiner wird. Bei leitendem Schalttransistor 11 fließt der Strom IV dabei über das Magnetventil 10, den Schalttransistor 11 und den Meßwiderstand 12, während bei gesperrtem Schalttransistor 11 der Strom IV vom Magnetventil 10 über die Diode 14 und den Freilauftransistor 13 abfließt. Die Spannung am Magnetventil 10 ist gemäß der beiden Figuren 2 und 3 bei leitendem Transistor 11 auf positiven Potential, während sie bei gesperrtem Transistor 11 Null ist. Das Steuern des Stromes IV durch das Magnetventil 10 hin zu größeren und zu kleineren Werten, also das Takten des Ventilstroms IV wird bis zum Zeitpunkt t4 fortgesetzt. Bewirkt wird das Takten zwischen den beiden Zeitpunkten t3 und t4 einzig und allein durch das Hin- und Herschalten des Schalttransistors 11. Der Freilauftransistor 13 ist während dieser gesamten Zeitdauer leitend geschaltet und der Steuertransistor 17 weiterhin gesperrt. Der Zeitpunkt t4 kennzeichnet das Ende der Ansteuerung des Magnetventils 10, das Magnetventil 10 soll also jetzt möglichst schnell wieder in seinen Ausgangsbetriebszustand übergehen. Dies wird dadurch erreicht, daß im Zeitpunkt t4 das Grund-Ansteuersignal To gemäß der Figur 4a wieder auf Masse zurückgesetzt wird, und gemäß der Figuren 4b bis d der Schalttransistor 11 und der Freilauftransistor 13 gesperrt werden der Steuertransistor 17 jedoch in seinen leitenden Betriebszustand gebracht wird. Floss bisher zwischen den beiden Zeitpunkten t3 und t4 der Strom IV entweder über die Elemente 10, 11, 12 oder 10, 14, 13, so sind jetzt nach dem Zeitpunkt t4 diese Stromwege durch die gesperrten Transistoren 11 und 13 nicht mehr möglich. Da der Strom IV durch das Magnetventil 10 nicht springen kann und im Zeitpunkt t4 noch positiv ist, fließt zwischen dem Zeitpunkt t4 und dem Zeitpunkt t5 der Strom IV über das Magnetventil 10, die Diode 15, die Steuerkapazität 16 und den Meßwiderstand 12 nach Masse. Der Strom IV wird dabei ab dem Zeitpunkt t4 immer kleiner und ist im Zeitpunkt t5 gleich Null. Nach dem Zeitpunkt t5 wechselt die Richtung des Stroms IV durch das Magnetventil 10, der Ventilstrom IV wird also, wie dies auch in den beiden Figuren 2 und 3 dargestellt ist, negativ. Dies bedeutet, daß jetzt, also nach dem Zeitpunkt t5 die Steuerkapazität 16 aufgrund ihrer anliegenden Spannung UC einen Strom gegen die Batteriespannung UB über den Steuertransistor 17 in das Magnetventil 10 treibt. Da jedoch in der Steuerkapazität 16 nur eine begrenzte Energie gespeichert ist, erreicht dieser negative Strom IV durch das Magnetventil 10 relativ schnell seinen maximalen negativen Wert, und steigt dann wieder an, um im Zeitpunkt t7 zu Null zu werden. Da im Zeitpunkt t4, wie ausgeführt wurde, der Steuertransistor 17 leitend geschaltet wird, wird in diesem Zeitpunkt t4 die Spannung UV am Magnetventil 10 auf einen großen, negativen Wert geschaltet. Ab dem Zeitpunkt t5 steigt die Ventilspannung UV jedoch wieder an, um im Zeitpunkt t6 von negativen wieder auf positive Werte überzugehen. Im Zeitpunkt t7 wird die Spannung UV am Magnetventil 10, wie auch der Ventilstrom IV, endgültig zu Null.

Es sei noch darauf hingewiesen, daß zwischen den beiden Zeitpunkten t3 und t4 auch der Freilauftransistor 13 taktend betrieben werden kann. Wichtig ist hierbei nur, daß sich der Freilauftransistor 13 in seinem leitenden Betriebszustand befindet, wenn der Schalttransistor 11 sperrt. Ebenfalls ist es möglich, den Steuertransistor 17 nicht im Zeitpunkt t4 leitend zu schalten, sondern zu einem späteren Zeitpunkt. Der letztmögliche Zeitpunkt des Umschaltens des Steuertransistors 17 ist dabei jedoch der Zeitpunkt t5, also der Nulldurchgang des Stroms IV durch das Magnetventil 10.

Die Zeitpunkte to und t4, also das Grund-Ansteuersignal des Magnetventils 10, können vom Anwender der beschriebenen erfindungsgemäßen Schalteinrichtung frei vorgegeben werden. Der Zeitpunkt t1 kann z.B. von der Steuerund/oder Regeleinrichtung 19 mit Hilfe der Meßspannung UM2 erkannt werden, um dann die entsprechenden Maßnahmen zur Strombegrenzung des Ventilstroms IV zu ergreifen. Beim Zeitpunkt t2 handelt es sich, wie schon ausgeführt wurde, um den Ventilanschlagszeitpunkt. Wie ebenfalls schon angedeutet wurde, kann der Zeitpunkt t2 bei Betrieb nach Figur 2 z.B. mit Hilfe der Meßspannung UM1 und damit aufgrund des Knicks in der Ventilspannung UV erkannt werden, oder bei Betrieb nach Figur 3 mit Hilfe der Meßspannung UM2 und damit mit Hilfe des Knicks im Strom IV durch das Magnetventil 10. Der Zeitpunkt t3 ist, wie schon erwähnt wurde, dann erreicht, wenn nach dem Zeitpunkt t2 der Ventilstrom IV den Wert des Haltestroms IH1 zum ersten Mal erreicht hat. Das nachfolgende Takten ist dann durch die beiden Halteströme IH1 und IH2 definiert.

Der besondere Vorteil der erfindungsgemäßen Schalteinrichtung entsteht nun durch die gesteuerte Kapazität 16. Diese Kapazität 16 wird nach dem Ventilanschlagzeitpunkt t2 aufgrund der gesperrten Transistoren 11 13 und 17 aufgeladen, und zwar abhängig von der Dimensionierung auf einen sehr hohen Wert. Nach der Auflladung, also während des Taktens des Stroms IV bleibt die Spannung UC an der Kapazität 16 konstant. Nach dem Zeitpunkt t4, wenn also das Magnetventil 10 möglichst schnell wieder in seinen Ausgangszustand übergeführt werden soll, erzeugt die Kapazität 16 aufgrund der an ihr anliegenden hohen Spannung UC einen schnellen Abfall des Stromes IV und schließlich einen negativen Strom IV durch das Magnetventil 10. Dies bewirkt, daß das Magnetventil 10 nicht nur in seinen Ausgangszustand zurückfällt, sondern aktiv in diesen Ausgangszustand zurückgeschaltet wird. Insgesamt ist es also mit Hilfe der Steuerkapazität 16 möglich, das Magnetventil 10 sehr schnell wieder in seinen Ausgangszustand zu schalten.

Außer den kurzen Schaltzeiten hat die erfindungsgemäße Schalteinrichtung auch noch den Vorteil, daß durch die beiden Zeitpunkte t2 und t4 der Zustand des Magnetventils genau definiert ist. Befindet sich z.B. das Magnetventil vor dem Zeitpunkt t0 in seinem geschlossenen Zustand, so ist es exakt im Zeitpunkt t2 in seinen geöffneten Zustand übergegangen, und kurz nach dem Zeitpunkt t4 wieder geschlossen. Mit Hilfe dieser eindeutig definierten Betriebszustände ist es dann möglich, einen Zeit-Regelkreis aufzubauen.

Zuletzt bietet die erfindungsgemäße Schalteinrichtung, insbesondere im Vergleich zum Stand der Technik noch den Vorteil, daß bei ihr nur eine relativ geringe Verlustleistung auftritt, da die Energie der Stromlöschung mit Hilfe der Kapazität in das Magnetventil zurückgespeist wird. Bei der möglichen Realisierung der erfindungsgemäßen Schalteinrichtung gemäß der Figur 2, also mit Strombegrenzung, wird die Strombelastung der gesamten Schaltung zu einem Minimum und auch die Verlustleistung nimmt nur wenig zu. Die magnetische Sättigung des Magnetventils wird in diesem Fall begrenzt, so daß der Zeitpunkt t2 besonders sicher erkannt werden kann. Abschließend sei noch darauf hingewiesen, daß die beschriebene erfindungsgemäße Schalteinrichtung nicht nur auf den in der Figur 1 beschränkten schaltungstechnischen Aufbau festgelegt ist. Es ist auch möglich, diese Schaltung, sowie die einzelnen Elemente der Schaltung im Rahmen des allgemeinen Fachwissens zu verändern und/oder zu erweitern. Derartige Veränderungen und/oder Erweiterungen verlassen jedoch nicht den Bereich der Erfindung, wenn sie den Kern der Erfindung, nämlich die zum Schalttransistor parallel geschaltete steuerbare Kapazität, noch enthalten. Dabei muß jedoch die steuerbare Kapazität nicht auf ein diskretes elektrisches Bauelement eingeschränkt sein, sondern kann auch z.B. mit Hilfe elektronischer oder sonstiger Schaltungen nachgebildet sein.

**Ansprüche**

1. Schalteinrichtung zum schnellen Schalten elektromagnetischer Verbraucher, mit einer Serienschaltung bestehend aus wenigstens dem elektromagnetischen Verbraucher (10) und einer ersten Schaltvorrichtung (11), mit wenigstens einer Freilaufdiode (14) für den elektromagnetischen Verbraucher (10), bei der parallel zu der ersten Schaltvorrichtung (11) eine Kapazität (16) schaltbar ist, dadurch gekennzeichnet, daß der Lade- bzw. Entladeweg der Kapazität (16) mit Hilfe einer zu ihr seriell geschalteten zweiten Schaltvorrichtung (17) derart schaltbar ist, daß die Kapazität (16) während des Sperrzustandes der ersten Schaltvorrichtung (11) vermittels des den Verbraucher (10) durchfließenden Stroms auf- und entladbar ist.

2. Schalteinrichtung nach Anspruch 1, dadurch gekennzeichnet, daß in Serie zu der Kapazität (16) eine Diode (15) geschaltet ist.

3. Schalteinrichtung nach einem der Ansprüche 1 und 2, dadurch gekennzeichnet, daß die Diode (15) parallel zu der zweiten Schaltvorrichtung (17) geschaltet ist.

4. Schalteinrichtung nach einem der Ansprüche 1 bis 3, dadurch gekennzeichnet, daß eine dritte Schaltvorrichtung (13) vorgesehen ist, die in Serie zu der Freilaufdiode (14) geschaltet ist.

5. Schalteinrichtung nach einem der Ansprüche 1 bis 4, dadurch gekennzeichnet, daß sie im Zusammenhang mit der Zumessung von Kraftstoff in einen Brennraum einer Brennkraftmaschine verwendet wird.

6. Schalteinrichtung nach einem der Ansprüche 1 bis 5 dadurch gekennzeichnet, daß es sich bei dem elektromagnetischen Verbraucher (10) um ein Magnetventil zum Einspritzen von Kraftstoff in den Brennraum einer Brennkraftmaschine handelt.

7. Verfahren zum Betrieb einer Schalteinrichtung mit einer Serienschaltung bestehend aus wenigstens einem elektrischen Verbraucher (10) und einer ersten Schaltvorrichtung (11), mit wenigstens einer Freilaufdiode (14) für den elektromagnetischen Verbraucher (10), einer parallel zu der ersten Schaltvorrichtung (11) schaltbaren Kapazität (16), einer zweiten Schaltvorrichtung (17) in Serie zu der Kapazität (16), sowie einer dritten Schaltvorrichtung (13) in Serie zu der Freilaufdiode (14), dadurch gekennzeichnet, daß während einer ersten Zeitdauer nur die seriell zu dem elektromagnetischen Verbraucher (10) liegende erste Schaltvorrichtung (11) durchgeschaltet wird.

8. Verfahren nach Anspruch 7, dadurch gekennzeichnet, daß während einer zweiten Zeitdauer sämtliche Schaltvorrichtungen (11,13,17) nicht durchgeschaltet werden.

9. Verfahren nach einem der Ansprüche 7,8 dadurch gekennzeichnet, daß während einer dritten Zeitdauer die in Serie zu dem elektromagnetischen Verbraucher (10) liegende Schaltvorrichtung (11) abwechselnd von ihrem durchgeschalteten in ihren nicht durchgeschalteten Betriebszustand und umgekehrt geschaltet wird.

10. Verfahren nach einem der Ansprüche 7 bis 9, dadurch gekennzeichnet, daß während einer vierten Zeitdauer nur die in Serie zu der Kapazität (16) geschaltete Schaltvorrichtung (17) durchgeschaltet wird.

11. Verfahren nach einem der Ansprüche 7 bis 10, dadurch gekennzeichnet, daß während der ersten Zeitdauer die seriell zum elektromagnetischen Verbraucher (10) liegende Schaltvorrichtung (11) zumindest zeitweise den Strom durch den elektromagnetischen Verbraucher (10) begrenzt.

12. Verfahren nach Anspruchs 11, dadurch gekennzeichnet, daß mit Hilfe der Strombegrenzung die magnetische Sättigung des elektromagnetischen Verbrauchers (10) beeinflußt wird, und daß dadurch das Ende der erste Zeitdauer besonders sicher erkannt wird.

## Claims

1. Switching device for the fast switching of electromagnetic loads, with a series circuit consisting of at least the electromagnetic load (10) and a first switching device (11), with at least one free-wheeling diode (14) for the electromagnetic load (10), in which a capacitance (16) can be connected in parallel with the first switching device (11), characterized in that the charging and discharging path of the capacitance (16) can be switched with the aid of a second switching device (17) serially connected to it, in such a manner that the capacitance (16) can be charged and discharged by means of the current flowing through the load (10) during the blocked state of the first switching device (11).

2. Switching device according to Claim 1, characterized in that a diode (15) is connected in series with the capacitance (16).

3. Switching device according to one of Claims 1 and 2, characterized in that the diode (15) is connected in parallel with the second switching device (17).

4. Switching device according to one of Claims 1 to 3, characterized in that a third switching device (13) is provided which is connected in series with the freewheeling diode (14).

5. Switching device according to one of Claims 1 to 4, characterized in that it is used in conjunction with the proportioning of fuel into a combustion space of an internal combustion engine.

6. Switching device according to one of Claims 1 to 5, characterized in that the electromagnetic load (10) is a solenoid valve for injecting fuel into the combustion space of an internal combustion engine.

7. Method for operating a switching device with a series circuit consisting of at least one electric load (10) and a first switching device (11), with at least one free-wheeling diode (14) for the electromagnetic load (10), a capacitance (16) which can be connected in parallel with the first switching device (11), a second switching device (17) in series with the capacitance (16), and a third switching device (13) in series with the free-wheeling diode (14), characterized in that only the first switching device (11) connected serially with the electromagnetic load (10) is switched to conduct during a first period of time.

8. Method according to Claim 7, characterized in that all switching devices (11, 13, 17) are not switched to conduct during a second period of time.

9. Method according to one of Claims 7, 8, characterized in that the switching device (11) connected in series with the electromagnetic load (10) is alternately switched from its conducting operating state to its non-conducting operating state and conversely during a third period of time.

10. Method according to one of Claims 7 to 9, characterized in that only the switching device (17) connected in series with the capacitance (16) is switched to conduct during a fourth period of time.

11. Method according to one of Claims 7 to 10, characterized in that the switching device (11) connected serially to the electromagnetic load (10) at least temporarily limits the current through the electromagnetic load (10) during the first period of time.

12. Method according to Claim 11, characterized in that the magnetic saturation of the electromagnetic load (10) is influenced with the aid of the current limiting and that as a result, the end of the first period of time is detected particularly reliably.

**Revendications**

1. Circuit de commutation pour la commutation rapide de charges électromagnétiques comportant un montage en série formé d'au moins une charge électromagnétique (10) et au moins un premier dispositif de commutation (11) avec au moins une diode en roue libre (14) pour la charge électromagnétique (10), un condensateur (16) pouvant être commandé en parallèle sur le premier dispositif de commutation (11), circuit caractérisé en ce que le chemin de charge et de décharge du condensateur (16) est commuté à l'aide d'un second dispositif de commutation (17) branché en série sur ce condensateur pour que pendant l'état de blocage du premier dispositif de commutation (11), un courant de charge et de décharge puisse traverser le condensateur (16) par l'intermédiaire de la charge (10).

2. Circuit de commutation selon la revendication 1, caractérisé par une diode (15) branchée en série sur le condensateur (16).

3. Circuit de commutation selon l'une des revendications 1 et 2, caractérisé en ce que la diode (15) est branchée en parallèle sur le second dispositif de commutation (17).

4. Circuit de commutation selon l'une des revendications 1 à 3, caractérisé par un troisième dispositif de commutation (13) branché en série sur la diode de roue libre (14).

5. Circuit de commutation selon l'une des revendications 1 à 4, caractérisé en ce qu'il est appliqué en liaison avec le dosage du carburant dans une chambre de combustion d'un moteur à combustion interne.

6. Circuit de commutation selon l'une des revendications 1 à 5, caractérisé en ce que la charge électromagnétique (10) est l'électrovanne d'injection de carburant dans la chambre de combustion d'un moteur à combustion interne.

7. Procédé de mise en oeuvre d'un circuit de commutation avec un montage en série formé d'au moins une charge électrique (10) et un premier dispositif de commutation (11), au moins une diode de roue libre (14) pour l'utilisateur électromagnétique (10), un condensateur (16), commutable en parallèle sur le premier dispositif de commutation (11), un second dispositif de commutation (17) en série sur le condensateur (16) ainsi qu'un troisième dispositif de commutation (13) en série sur la diode de roue libre (14), procédé caractérisé en ce qu au cours d'une première période seul le premier dispositif de commutation (11) en série sur la charge électromagnétique (10) est passant.

8. Procédé selon la revendication 7, caractérisé en ce qu'au cours d'une seconde période, tous les dispositifs de commutation (11, 13, 17) sont bloqués.

9. Procédé selon l'une des revendications 7, 8, caractérisé en ce que pendant une troisième période, le dispositif de commutation (11) en série sur la charge électromagnétique (10) est commandé en alternance entre son état passant et son état bloqué et inversement.

10. Procédé selon l'une des revendications 7 à 9, caractérisé en ce qu'au cours d'une quatrième période, seul le dispositif de commutation (17) en série sur le condensateur (16) est passant.

11. Procédé selon l'une des revendications 7 à 10, caractérisé en ce que pendant la première période, le dispositif de commutation (11) en série sur la charge électromagnétique (10) limite au moins de temps à autre le courant traversant la charge électromagnétique (10).

12. Procédé selon la revendication 11, caractérisé en ce qu'à l'aide de la limitation d'intensité, on influence la saturation magnétique de la charge électromagnétique (10) et on détecte ainsi de manière particulièrement sûre la fin de la première période.

FIG.1

EP 0 182 101 B1

$$\frac{dIV}{dt}=0$$

FIG.2

UC=const.

$$\frac{dIV}{dt}=0$$

FIG.3

UC=const.

FIG.4A

FIG.4B

FIG.4C

FIG.4D